# EUROPÄISCHE PATENTANMELDUNG

(11) **EP 0 882 965 A1**
(43) Veröffentlichungstag der Anmeldung: **09.12.1998**
(21) Anmeldenummer: 98109893.2
(22) Anmeldetag: 27.05.1998
(51) Int. Cl.: G01L 9/00, H01L 23/31, H01L 23/29, H01L 21/56

(54) **Halbleiter-Drucksensor-Bauelement und Verfahren zur Herstellung**

(30) Priorität: 06.06.1997 DE 19724025
(71) Anmelder: SIEMENS AKTIENGESELLSCHAFT, 80333 München (DE)
(72) Erfinder: Bootz, Eric, 93309 Kelheim (DE); Janczek, Thies, 93055 Regensburg (DE); Neu, Achim, 93047 Regensburg (DE); Stadler, Bernd, 93093 Dobaustauf (DE); Winterer, Jürgen, 90451 Nürnberg (DE)

(57) **Zusammenfassung**

Die Erfindung bezieht sich auf ein Drucksensor-Bauelement mit einem Chipträger (3), auf welchem ein Halbleiterchip (4) mit einem integriert ausgebildeten Drucksensor angeordnet ist, der eine dem zu messenden Druck (P) ausgesetzte Druckerfassungsfläche (5) besitzt, und mit einer den Halbleiterchip (4) und/oder den Chipträger (3) sowie der für die Verbindung zwischen den nach außen geführten Elektrodenanschlüssen (8, 9) und dem Drucksensor bzw. elektronischen Schaltung des Halbleiterchips (4) angeordneten Bonddrähte (7) wenigstens bereichsweise umschließenden Bauelementverkapselung (6) aus einem elektrisch isolierenden Material, wobei der Chipträger (3) elektrisch mit dem Drucksensor bzw. einer dem Drucksensor zugeordneten elektronischen Schaltung des Kalbleiterchips (4) verbundene Elektrodenanschlüsse (8, 9) aufweist, welche Elektrodenanschlüsse (8, 9) die Bauelementverkapselung (6) durchsetzen, wobei wenigstens der der Druckerfassungsfläche (5) des Drucksensors zugeordnete Abschnitt der Bauelementverkapselung (6) durch ein homogenes Druckübertragungsmedium bestehend aus einer den zu messenden Druck (P) möglichst verzögerungs- und dämpfungsfrei übertragenden, jedoch mechanisch widerstandsfähigen, jedenfalls nach einer gegebenenfalls durchgeführten Aushärtung im Wesentlichen formstabilen Hüllmasse (6) dergestalt ausgebildet bzw. angeordnet ist, dass der zu messende Druck (P) durch die Hüllmasse (6) unmittelbar auf die Druckerfassungsfläche (5) des Halbleiterchips (4) geführt ist, und eine allseitig dichte Abdeckung des Drucksensors bzw. des Drucksensor-Bauelementes (1) gegenüber mechanischen und/oder chemischen Einflüssen gegeben ist. Die gesamte Bauelementverkapselung (6) besteht aus der Hüllmasse.

## Beschreibung

Die Erfindung bezieht sich auf ein Drucksensor-Bauelement nach dem Oberbegriff des Anspruches 1 und ein Verfahren zur Herstellung eines Drucksensor-Bauelementes nach dem Oberbegriff des Anspruches 7.

Zur Messung von Drücken muss das zu messende Medium an den Sensor herangeführt bzw. der in dem Medium herrschende Druck an den Sensor übertragen werden. Andererseits erfordert die Applikation eines Halbleiter-Drucksensors in der endgültigen Anwendung die geschützte Verkapselung des Sensorchips durch Umhüllung mit einem geeigneten Material, in der Regel Kunststoff. Die Umhüllung bzw. Verkapselung des Sensorchips erfordert mehrere Prozess-Schritte, bei denen dem Bauelement die endgültige Form gegeben wird und ein elektrisches Anschlusskabel nach dem Verlöten mit der Leiterplatine umspritzt wird.

Bekannt ist ferner die Applikation des in aller Regel auf dem Grundmaterial Silizium beruhenden Halbleiterchips in einem starren Gehäuse, beispielsweise DIP-Gehäuse (Dual-Inline-Package-Gehäuse), SMD-Gehäuse (Surface-Mounted-Design-Gehäuse) oder auch in Sonderbauformen, wobei dieses Gehäuse nachfolgend auf einer Leiterplatte bestückt wird. Bei einer bekannten Ausführung erfolgt die Druckankopplung über eine den empfindlichen Sensor abdeckende und somit schützende Membran aus Metall oder auch Kunststoff, welche auch als separates Zusatzbauteil ausgeführt sein kann. Probleme ergeben sich hierbei oftmals aufgrund einer nur unzureichenden Druckeinkopplung durch das Gehäuse bis zum Sensorchip bei gleichzeitigem Schutz des Sensors. Generell ist eine einfach zu fertigende und dichte Verbindung zwischen dem zu messenden Medium und dem Sensor gefordert, um eine die Druckmessung verfälschende Einströmung von Fremdluft zu vermeiden. Andererseits ist in vielen Fällen darüber hinaus eine Trennung des zu messenden Mediums von den metallischen Bestandteilen des Sensors sowie vom Halbleiterchip erforderlich, um die Gefahr einer Korrosion oder eines zerstörenden Einflusses durch das Medium auf die empfindlichen Bestandteile des Sensors zu vermeiden. Andere Ausführungen von bekannten Drucksensor-Bauelementen sehen ein offenes Gehäuse vor, bei dem der Schutz des Sensorchips gegen Umwelteinflüsse nur als zweitrangiges Problem angesehen wird, und der Sensorchip nicht geschützt ist. Solche Bauformen sind in der Regel nur für nicht aggressive Medien geeignet.

Aus der DE 42 38 113 A1 ist ein Drucksensor-Bauelement nach dem Oberbegriff des Anspruches 1 bekannt geworden, bei dem der Halbleiterchip allseitig mit einem elastischen Material (Silikonkautschuk) umgeben ist, das gleichzeitig zur Chipbefestigung und -umhüllung dient. Die Anordnung bestehend aus Halbleiterchip und Silikonkautschuk-Umhüllung ist in einem üblichen Gehäuse aus Plastmaterial verkapselt.

Aus der DE 42 03 832 A1 ist ein Halbleiter-Druckaufnehmer in üblicher Bauart bekannt.

Aus David J. Beebe et al. In: Sensors and Actuators, Vol. A 50, 1995, S. 55 - 65 ist ein Drucksensor-Bauelement mit einer relativ dicken Membranstruktur bekannt. Die angelegte Druckkraft wird an die Membran über eine domartige Festkörperstruktur geleitet.

Aus der DE 40 06 450 A1 ist die Verwendung von Polyimidharzmassen für die Einkapselung von Halbleiter-Bauelementen bekannt.

Allen bislang bekannten Bauformen von Halbleiter-Drucksensoren gemeinsam ist, dass zur Herstellung stets ein mehrstufiger Prozess zur Umhüllung bzw. Verkapselung des Bauelementes erforderlich ist, mit welchem das Bauelement in seine gewünschte Bauform gebracht wird.

Der Erfindung liegt die Aufgabe zugrunde, ein Drucksensor-Bauelement bzw. ein Verfahren zur Herstellung eines Drucksensor-Bauelementes der eingangs genannten Gattung zur Verfügung zu stellen, bei dem die Verkapselung des den mechanisch empfindlichen Drucksensor tragenden Halbleiterchips beziehungsweise des Chipträgers konstruktiv einfacher und damit auch kostengünstiger erfolgen kann, und gleichzeitig eine vergleichsweise einfach einzurichtende aber dennoch hinreichend dichte Verbindung zwischen dem zu messenden Medium und dem Drucksensor gewährleistet werden kann.

Die Lösung dieser Aufgabe erfolgt vorrichtungsmäßig mit den kennzeichnenden Merkmalen des Anspruchs 1, verfahrensmäßig mit den kennzeichnenden Merkmalen des Anspruchs 7.

Erfindungsgemäß ist vorgesehen, dass die gesamte Bauelementverkapselung aus der Hüllmasse besteht. Das erfindungsgemäße Verfahren zur Herstellung des Drucksensor-Bauelementes sieht vor, nach der Montage und Kontaktierung des Halbleiterchips auf dem Chipträger das Bauelement mit einer den Halbleiterchip und/oder den Chipträger umschließenden Bauelementverkapselung aus einem elektrisch isolierenden Material vorzusehen, wobei wenigstens der der Druckerfassungsfläche des Drucksensors zugeordnete Abschnitt der Bauelementverkapselung ein homogenes Druckübertragungsmedium bestehend aus einer den zu messenden Druck möglichst verzögerungs- und dämpfungsfrei übertragenden, jedoch mechanisch widerstandsfähigen, jedenfalls nach einer gegebenenfalls durchgeführten Aushärtung im Wesentlichen formstabilen Hüllmasse dergestalt ausgebildet bzw. angeordnet wird, dass der zu messende Druck durch die Hüllmasse unmittelbar auf die Druckerfassungsfläche des Halbleiterchips geführt ist, und eine allseitig dichte Abdeckung des Drucksensors bzw. des Drucksensor-Bauelementes gegenüber mechanischen und/oder chemischen Einflüssen gegeben ist. Ein besonders einfaches und damit kostengünstiges Herstellen durch Reduzierung der Prozess-Schritte sowie Einsparung von aufgewendetem Material ergibt sich, wenn nach der Erfindung die gesamte Bauelementverkapselung aus der Hüllmasse besteht. Der Sensor ist durch die das Drucksensor-Bauelement vollständig umhüllende Hüllmasse gegen Umwelteinflüsse geschützt, wobei die zu messenden Drücke verlust- und verzögerungsfrei übertragen werden. Gleichzeitig kann das Bauelement von Vorteil sowohl in seiner Baugröße als auch seinem Gewicht minimiert werden.

In besonders bevorzugter Weise wird beim erfindungsgemäßen Herstellungsverfahren das Verkapseln des Drucksensor-Bauelementes durch ein LSR-(Liquid Silicon Rubber)-Verfahren ausgeführt, bei dem die in einem Hohlraum einer Spritzgussform eingelegten Komponenten des Bauelementes mit einem Flüssigsilikonkautschuk oder -gummi umspritzt werden, und daran anschließend bei vergleichsweise geringem Druck und einer Wärmebehandlung der Silikonkautschuk oder -gummi ausgehärtet wird.

Den äußeren Abmessungen und Erscheinungsformen der aus der Hüllmasse bestehenden Bauelementverkapselung sind an sich keine Grenzen gesetzt; durch Ändern der Gehäuseform bzw. Anpassung des bei der Verkapselung des Bauelementes zum Einsatz kommenden Spritzwerkzeuges kann der Sensor bei gleicher Funktion für verschiedene Anwendungen ausgebildet sein. Denkbar sind beispielsweise Steck- oder Schnappverbindungen, wie sie in der Automobilindustrie verwendet werden.

Bei einer bevorzugten Ausführung der Erfindung stellt die Hüllmasse des den zu messenden Druck übertragenden Druckübertragungsmediums ein Gummi- oder Kautschuk- oder ein gummi- oder kautschukartiges Material, vorzugsweise ein insbesondere thermisch vernetzbares Silikonkautschuk- oder Silikongummimaterial dar.

Bei der Ausbreitung der Druckwellen erfahren diese in der Hüllmasse zum Einen zeitliche Verzögerungen und zum Anderen Verluste. Es wird eine Abnahme der Intensität der Druckwellen beobachtet, die entsprechend der Ausbreitung von Schall als Dissipation bezeichnet wird und von der Schallabsorption an schallschluckenden Wandflächen zu unterscheiden ist. Man beobachtet eine exponentielle Abnahme der Intensität der Druckwellen mit zunehmender Entfernung mit einem Proportionalitätsfaktor als Dissipationskonstante, die vom Material der Hüllmasse abhängt. Die Dissipation der Druckwellen dürfte verschiedene Ursachen haben; vermutlich fallen Verluste durch Wärmeleitung am stärksten ins Gewicht. Eine annähernd verlust- und verzögerungsfreie Übertragung des zu messenden Druckes an den Drucksensor ergibt sich, wenn die zur Druckübertragung wirksame Schichtstärke des Druckübertragungsmediums oberhalb der Druckerfassungsfläche maximal etwa 300 µm, vorzugsweise maximal 100 µm bis 200 µm beträgt. Die gezielte Verwendung einer sehr dünnen Schicht von etwa 100 µm gewährleistet somit eine minimale Druckverzögerung bzw. -dämpfung sowie Empfindlichkeit gegenüber Beschleunigungen und damit verbundenen Rückwirkungen auf die Druckmessungen des Sensorchips. Gleichzeitig ist der Chip noch ausreichend gegen chemische Umwelteinflüsse geschützt, und ein mechanischer Schutz abhängig vom gewünschten Design in einem gewissen Grad gewährleistet.

Weitere bevorzugte Ausführungen der Erfindung ergeben sich aus den Unteransprüchen.

Nachfolgend wird die Erfindung anhand von in der Zeichnung dargestellten Ausführungsbeispielen weiter erläutert. Im Einzelnen zeigen die schematischen Darstellungen in:
- Figur 1: eine Schnittansicht durch ein Drucksensor-Bauelement für die Oberflächenmontage, bei dem das Drucksensorgehäuse vollständig aus einer flexiblen Hüllmasse besteht; und
- Figur 2: eine Schnittansicht eines Drucksensor-Bauelementes mit einer Verkapselung bestehend aus einer flexiblen Hüllmasse, bei dem der elektrische Anschluss vermittels eines ein- oder mehradrigen Kabels, welches die Hüllmasse durchsetzt, erfolgt.

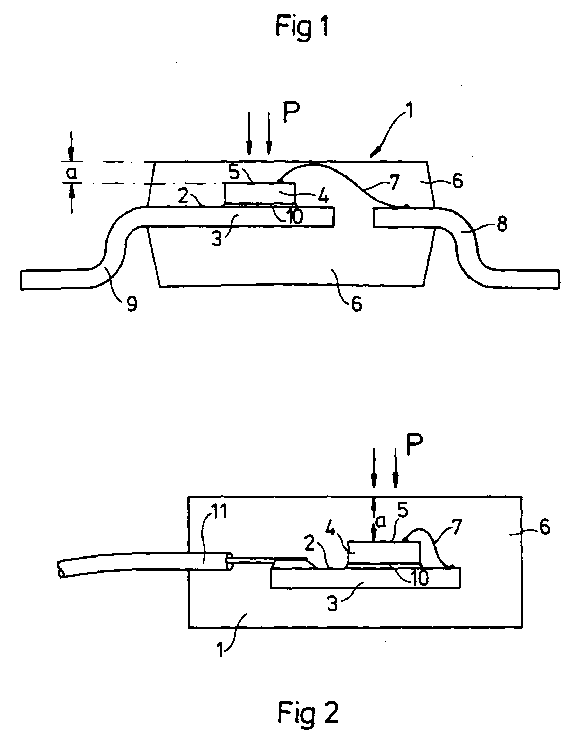

Figur 1 zeigt ein Ausführungsbeispiel eines erfindungsgemäßen Drucksensor-Bauelementes 1 für eine Oberflächenmontage auf der Bestückungsfläche einer Leiterplatte. Das Drucksensor-Bauelement 1 besitzt einen eine annähernd ebene Chipträgerfläche 2 aufweisenden Chipträger 3 aus elektrisch leitendem Material, auf welcher Chipträgerfläche 2 ein Halbleiterchip 4 aus Silizium-Grundmaterial mit einem integriert ausgebildeten Drucksensor und diesem zugeordneter elektronischer Schaltung befestigt ist, wobei der Drucksensor und die Schaltung in den Figuren nicht näher dargestellt sind, sondern lediglich schematisch eine Druckerfassungsfläche 5 angedeutet ist, die dem zu messenden Druck P ausgesetzt ist. Als Schutz gegen äußere Umwelteinflüsse besitzt das Drucksensor-Bauelement 1 eine den Halbleiterchip 4 und/oder den Chipträger 3 wenigstens bereichsweise umschließende Bauelementverkapselung 6 aus einem elektrisch isolierenden Material. Der Chipträger 3 ist in an sich bekannter Bauart als sogenanntes "Leadframe", d.h. als vorgefertigtes Chipträgersubstrat ausgebildet und besitzt eine Vielzahl von die Bauelementverkapselung 6 durchsetzenden, vermittels Bonddrähte 7 elektrisch mit dem Drucksensor bzw. der diesem zugeordneten elektronischen Schaltung des Halbleiterchips verbundenen Elektrodenanschlüssen 8, 9 (in Figur 1 sind lediglich zwei Elektrodenanschlüsse dargestellt, wobei der Elektrodenanschluss 9 über eine Rückseitenkontaktierung 10 direkt mit der Unterseite des Halbleiterchips 4 elektrisch gekoppelt ist), die in der Form von nach wenigstens zwei Seiten des Chipträgers 3 herausgeführten Anschlussbeinchen ausgebildet sind, die in bekannter Weise zu kurzen schwingenförmigen Anschluss-Stummeln gebogen und geschnitten sind. Eine solche Anordnung gewährleistet die Montage des Bauelementes 1 auf der Bestückungsoberfläche einer (nicht näher dargestellten) Leiterplatte in SMD-Technik. Während bei dem dargestellten Ausführungsbeispiel für die elektrische Verbindung des auf dem Halbleiterchip 4 integriert ausgebildeten Drucksensors bzw. der diesem zugeordneten elektronischen Schaltung mit den Elektrodenanschlüssen 8, 9 ein Drahtkontaktierverfahren zum Einsatz gelangt, bei dem Bonddrähte 7 auf dem Chip 4 befestigt und an das entsprechend zu verbindende Elektrodenbeinchen 8 gezogen werden, kann darüber hinaus für diese elektrische Verbindung auch eine sogenannte Spider-Kontaktierung Verwendung finden, bei der anstelle von Bonddrähten eine elektrisch leitende Systemträgerplatte zum Einsatz gelangt, auf welcher der Chip 4 unmittelbar kontaktiert wird.

Der auf dem Halbleiterchip 4 aus Silizium integrierte Drucksensor stellt einen sogenannten piezoresistiven Sensor dar, bei dem eine in der Oberfläche des Chips 4 nach Methoden der Mikromechanik gefertigte dünne Silizium-Membran vorgesehen ist, die elektrisch mit druckabhängigen Widerständen gekoppelt ist, welche gleichfalls im Siliziumsubstrat ausgebildet sind und in an sich bekannter Weise in einer Brückenschaltung geschaltet sind. Gleichfalls im Halbleiterchip 4 integriert ist eine dem Sensor zugeordnete Schaltung, die der Signalaufbereitung (Verstärkung und Korrektur), aber auch einem Abgleich und einer Kompensation des Sensors dient. Gegenüber sonstigen Bauformen eignen sich solche, der Erfindung zugrunde liegenden Halbleiter-Drucksensoren vornehmlich für solche Anwendungen, bei denen es auf eine geringste Baugröße ankommt, also beispielsweise bei Druckmessungen im Kraftfahrzeugbereich, beispielsweise bei der Messung von Bremsdrücken, Reifendrücken, Brennraumdrücken und dergleichen. Neben Halbleiter-Drucksensoren, die nach dem Prinzip der piezoresistiven Druckmessung arbeiten, sind darüber hinaus auch solche verwendbar, die mit kapazitiven Messprinzipien arbeiten.

Erfindungsgemäß besteht die gesamte Bauelementverkapselung 6 aus einer den zu messenden Druck P möglichst verzögerungs- und dämpfungsfrei übertragenden, jedoch mechanisch widerstandsfähigen, jedenfalls nach einer gegebenenfalls durchgeführten Aushärtung im Wesentliche formstabilen Hüllmasse als homogenes Druckübertragungsmedium. Vorzugsweise weist die Hüllmasse 6 ein Silikonkautschukmaterial oder Silikongummimaterial auf, welches in zunächst flüssiger oder fließfähiger Konsistenz vorliegt und nach Formgebung durch eine Wärmebehandlung thermisch vernetzt wird und danach im Wesentlichen formstabil bleibt. Die zur Druckübertragung wirksame Schichtstärke a des Druckübertragungsmediums oberhalb der Druckerfassungsfläche 5 wird so gewählt, dass der zu messende Druck möglichst verzögerungs- und dämpfungsfrei übertragen werden kann, und gleichzeitig die vermittels Low Loop Bonding gefertigten Bonddrähte 7 geringer Schleifenhöhe noch vollständig innerhalb des Verkapselungsmaterials 6 eingebettet sind. Eine Schichtstärke a von etwa 100 µm bewirkt eine nur geringe Druckverzögerung bzw. Dämpfung, gewährleistet in einem gewissen Grad noch ausreichenden mechanischen Schutz. In jedem Fall liegt die Schichtstärke a unterhalb von etwa 300 µm.

Figur 2 zeigt ein weiteres Ausführungsbeispiel der Erfindung, bei dem das Drucksensor-Bauelement 1 ebenfalls vollständig innerhalb einer flexiblen Hüllmasse 6 als Verkapselung integriert ist. Der Chipträger 3 liegt hier als kleineres Stück eines Trägers oder einer metallischen Leadframe-Insel vor, auf dem der Halbleiterchip 4 plaziert ist. Zur Kontaktierung dienen wiederum in Low Loop Technik gebondete Bonddrähte 7, sowie gegebenenfalls Rückseitenkontaktierungen 10 auf der Unterseite des Chips 4. Mit dem Träger 3 ist ein ein- oder mehradriges Kabel 11 verlötet, welches nur zu einem geringen Teil innerhalb der flexiblen Hüllmasse 6 zu liegen kommt. Die Schichtstärke a beträgt zur möglichst optimalen Druckübertragung wiederum etwa einige 100 µm, vorzugsweise maximal etwa 300 µm.

## Patentansprüche

1. Drucksensor-Bauelement mit einem Chipträger (3), auf welchem ein Halbleiterchip (4) mit einem integriert ausgebildeten Drucksensor angeordnet ist, der eine dem zu messenden Druck (P) ausgesetzte Druckerfassungsfläche (5) besitzt, und mit einer den Halbleiterchip (4) und/oder den Chipträger (3) sowie der für die Verbindung zwischen den nach außen geführten Elektrodenanschlüssen (8, 9) und dem Drucksensor bzw. elektronischen Schaltung des Halbleiterchips (4) angeordneten Bonddrähte (7) wenigstens bereichsweise umschließenden Bauelementverkapselung (6) aus einem elektrisch isolierenden Material, wobei der Chipträger (3) elektrisch mit dem Drucksensor bzw. einer dem Drucksensor zugeordneten elektronischen Schaltung des Kalbleiterchips (4) verbundene Elektrodenanschlüsse (8, 9) aufweist, welche Elektrodenanschlüsse (8, 9) die Bauelementverkapselung (6) durchsetzen, wobei wenigstens der der Druckerfassungsfläche (5) des Drucksensors zugeordnete Abschnitt der Bauelementverkapselung (6) durch ein homogenes Druckübertragungsmedium bestehend aus einer den zu messenden Druck (P) möglichst verzögerungs- und dämpfungsfrei übertragenden, jedoch mechanisch widerstandsfähigen, jedenfalls nach einer gegebenenfalls durchgeführten Aushärtung im Wesentlichen formstabilen Hüllmasse (6) dergestalt ausgebildet bzw. angeordnet ist, dass der zu messende Druck (P) durch die Hüllmasse (6) unmittelbar auf die Druckerfassungsfläche (5) des Halbleiterchips (4) geführt ist, und eine allseitig dichte Abdeckung des Drucksensors bzw. des Drucksensor-Bauelementes (1) gegenüber mechanischen und/oder chemischen Einflüssen gegeben ist,
dadurch **gekennzeichnet,**
dass die gesamte Bauelementverkapselung (6) aus der Hüllmasse besteht.

2. Drucksensor-Bauelement nach Anspruch 1,
dadurch **gekennzeichnet,**
dass die Hüllmasse des den zu messenden Druck (P) übertragenden Druckübertragungsmediums ein Gummi- oder Kautschuk- oder ein gummi- oder kautschukartiges Material aufweist.

3. Drucksensor-Bauelement nach einem der Ansprüche 1 bis 2,
dadurch **gekennzeichnet,**
dass die Hüllmasse des den zu messenden Druck (P) übertragenden Druckübertragungsmediums ein insbesondere thermisch vernetzbares Silikonkautschuk- oder Silikongummimaterial aufweist.

4. Drucksensor-Bauelement nach einem der Ansprüche 1 bis 3,
dadurch **gekennzeichnet,**
dass die zur Druckübertragung wirksame Schichtstärke des Druckübertragungsmediums oberhalb der Druckerfassungsfläche (5) maximal etwa 300 µm, vorzugsweise maximal 100 µm bis 200 µm beträgt.

5. Drucksensor-Bauelement nach einem der Ansprüche 1 bis 4,
dadurch **gekennzeichnet,**
dass die die Bauelementverkapselung (6) durchsetzenden Elektrodenanschlüsse (8, 9) eine oberflächenmontierbare Anordnung besitzen.

6. Drucksensor-Bauelement nach einem der Ansprüche 1 bis 5,
dadurch **gekennzeichnet,**
dass die Verbindung zwischen den nach außen geführten Elektrodenanschlüssen (8, 9) und dem Drucksensor bzw. elektronischen Schaltung des Halbleiterchips (4) vermittels Bonddrähten (7) geringer Schleifenbildung ("Low Loop Bonding") ausgebildet ist.

7. Verfahren zur Herstellung eines Drucksensor-Bauelementes (1) mit einem Chipträger (3), auf welchem ein Halbleiterchip (4) mit einem integriert ausgebildeten Drucksensor angeordnet ist, der eine dem zu messenden Druck ausgesetzte Druckerfassungsfläche (5) besitzt,
**gekennzeichnet** durch die Schritte:
- Montieren und Kontaktieren des Halbleiterchips (4) auf dem Chipträger (3),
- Verkapseln des Drucksensor-Bauelementes (1) mit einer den Halbleiterchip (4) und/oder den Chipträger (3) sowie der für die Verbindung zwischen den nach außen geführten Elektrodenanschlüssen (8, 9) und dem Drucksensor bzw. elektronischen Schaltung des Halbleiterchips (4) angeordneten Bonddrähte (7) umschließenden Bauelementverkapselung (6) aus einem elektrisch isolierenden Material, wobei wenigstens der der Druckerfassungsfläche (5) des Drucksensors zugeordnete Abschnitt der Bauelementverkapselung (6) ein homogenes Druckübertragungsmedium bestehend aus einer den zu messenden Druck (P) möglichst verzögerungs- und dämpfungsfrei übertragbaren, jedoch mechanisch widerstandsfähigen, jedenfalls nach einer gegebenenfalls durchgeführten Aushärtung im Wesentlichen formstabilen Hüllmasse dergestalt ausgebildet bzw. angeordnet wird, dass der zu messende Druck (P) durch die Hüllmasse unmittelbar auf die Druckerfassungsfläche (5) des Halbleiterchips (4) geführt ist, und eine allseitig dichte Abdeckung des Drucksensors bzw. des Drucksensor-Bauelementes (1) gegenüber mechanischen und/oder chemischen Einflüssen gegeben ist, wobei das Verkapseln des Drucksensor-Bauelementes (1) durch ein LSR-(Liquid Silicon Rubber)-Verfahren durchgeführt wird, bei dem die in einem Hohlraum einer Spritzgussform eingelegten Komponenten des Bauelementes (1) mit einem Flüssigsilikonkautschuk oder -gummi umspritzt werden, und daran anschließend bei vergleichsweise geringem Druck und einer Wärmebehandlung der Silikonkautschuk oder -gummi ausgehärtet wird.
